# EUROPÄISCHE PATENTSCHRIFT

(11) **EP 0 949 664 B1**
(45) Veröffentlichungstag und Bekanntmachung des Hinweises auf die Patenterteilung: **17.07.2002**
(21) Anmeldenummer: 98124016.1
(22) Anmeldetag: 17.12.1998
(51) Int. Cl.: H01L 21/8242

(54) **Verfahren zum Herstellen eines Stapelkondensators in einer Halbleiteranordnung**
Method of manufacturing a stacked capacitator in a semiconductor device
Procédé de fabrication d'un condensateur empilé dans un dispositif semiconducteur

(30) Priorität: 08.04.1998 DE 19815869
(43) Veröffentlichungstag der Anmeldung: 13.10.1999
(73) Patentinhaber: Infineon Technologies AG, 81669 München (DE)
(72) Erfinder: Willer, Josef Dr., 85521 Riemerling (DE); Bertagnolli, Emmerich Prof., 80799 München (DE)
(74) Vertreter: Kottmann, Heinz Dieter, Dipl.-Ing.

(56) Entgegenhaltungen:
- EP-A- 0 424 623
- DE-C- 19 546 999
- US-A- 5 721 152

## Beschreibung

Die vorliegende Erfindung betrifft ein Verfahren zum Herstellen eines Stapelkondensators in einer Halbleiteranordnung, bei dem eine Elektrode des Stapelkondensators über ein Anschlußgebiet des einen Leitfähigkeitstyps mit Söurce oder Drain eines Transistors verbunden ist und bei dem die eine Elektrode des Stapelkondensators unter Ausnutzung der unterschiedlichen Ätzgeschwindigkeiten von verschieden stark dotierten Halbleiterschichten des anderen Leitfähigkeitstyps erzeugt wird.

Die Begriffe p-dotiert, p⁺-dotiert, p⁻-dotiert, n-dotiert, n⁺-dotiert, n⁻-dotiert werden, wie es unter Fachleuten in der Halbleitertechnologie üblich ist, synonym mit den Abkürzungen p-, p⁺-, p⁻-, n-, n⁺-, n⁻- verwendet.

Bei einem aus DE 195 26 952 A1 bekannten Verfahren zur Herstellung einer DRAM-Zellenanordnung ist ein Speicherkondensator in einem Graben angeordnet und umfaßt eine Elektrodenstruktur mit mehreren zwiebelförmig gestalteten Elementen, deren Oberfläche mit einem Speicherdielektrikum und einer Gegenelektrode versehen ist. Diese Elektrodenstruktur wird unter Einsatz von zu p⁻-dotiertem Polysilizium selektivem Ätzen von p⁻-dotiertem Polysilizium hergestellt. Es wird hier also ausgenutzt, daß p⁻-dotiertes Polysilizium im Vergleich zu p⁺dotiertem Polysilizium wesentlich schneller (um einen Faktor in der Größenordnung 100) ätzbar ist. Bei der Herstellung eines aus der US 5 153 813 bekannten Graben-Speicherkondensators wird bei abwechselnd entgegengesetzt dotierten Halbleiterschichten ein Trockenätzen vorgenommen und dabei ausgenutzt, daß die entgegengesetzt dotierten Halbleiterschichten unterschiedliche Ätzraten haben. Auf diese Weise werden die Oberfläche und damit die Kapazität des Kondensators vergrößert.

Aus der US 5 637 523 ist ein Verfahren bekannt, bei dem zur Vergrößerung der Kondensatorfläche eines auf einem Halbleiterkörper angeordneten Stapelkondensators dieser aus abwechselnd angeordneten ersten und zweiten Halbleiterschichten gebildet wird, die unterschiedlich ätzbar sind. Beispiele für diese Schichten sind amorphes oder polykristallines Silizium mit unterschiedlichen Dotierungskonzentrationen.

In der US 5 053 351 ist ein Verfahren zum Herstellen eines Stapelkondensators für eine DRAM-Zelle beschrieben, bei dem abwechselnd polykristalline Schichten und dielektrische Schichten auf einen Halbleiterkörper aufgetragen werden und bei dem dann in einem selektiven Ätzschritt die dielektrischen Schichten entfernt werden, um so eine möglichst große Kondensatorfläche zu erzielen.

Schließlich ist aus der DE 195 46 999 C1 ein Verfahren zum Herstellen eines Stapelkondensators auf einem mit einem Transistor versehenen Halbleiterkörper bekannt, bei dem - ähnlich wie bei dem aus der DE 195 26 952 A1 bekannten Verfahren - die selektive Ätzbarkeit von p⁺-dotiertem Polysilizium und p⁻-dotiertem Polysilizium ausgenutzt wird, um eine lamellenartige Elektrode des Stapelkondensators zu erzeugen.

Das zuletzt genannte Verfahren hat sich infolge der hohen selektiven Ätzbarkeit von p⁺-Polysilizium und p⁻-Polysilizium als besonders erfolgreich erwiesen, um lamellen- oder blätterartige Strukturen aus p⁺-Polysilizium zu erzeugen, das als erste Elektrode des Stapelkondensators verwendet wird. Auf diese Elektrode wird bei dem bekannten Verfahren zunächst ein Dielektrikum (Siliziumoxid und/oder Siliziumnitrid bzw. ON oder auch ONO usw.) aufgetragen, wonach dann die Gegenelektrode gebildet wird.

Dieses bekannte Verfahren, das für die Herstellung eines Stapelkondensators äußerst zweckmäßig ist, hat jedoch einen für die Funktion einer den Stapelkondensator verwendenden Speicherzelle gravierenden Nachteil: die Kontaktierung der zwangsläufig infolge des Ätzprozesses p⁺-leitenden inneren Elektrode des Stapelkondensators mit dem aus anderen Gründen n⁺-leitenden Source/Drain-Anschlußgebiet des im Halbleiterkörper vorgesehenen Transistors ist nicht direkt möglich. Der hier vorliegende p⁺n⁺-Übergang bildet nämlich eine Diode, die die Funktion der DRAM-Zelle stark beeinträchtigt oder sogar vollständig verhindert. Aus diesem Grund wurde bisher daran gedacht, eine metallische Zwischenschicht zwischen dem n⁺leitenden Source/Drain-Anschlußgebiet des Transistors und der p⁺-leitenden Elektrode des Stapelkondensators vorzusehen, die für eine ohmsche Verbindung zwischen dem Anschlußgebiet und der Elektrode sorgt. Damit kann zwar für eine einwandfreie Funktion der Speicherzelle gesorgt werden. Das Einbringen der metallischen Zwischenschicht, die in dem Schichtenaufbau vergraben ist, hat sich aber als problematisch herausgestellt, da dadurch der weitere Herstellungsprozeß des Stapelkondensators verändert wird und bisher nicht zu lösende Prozeßvarianten erfordert.

Obwohl also die Ausnutzung der Ätzselektivität zwischen p⁺-Polysilizium und p⁻-Polysilizium bei der Herstellung eines Stapelkondensators wünschenswert ist, ist es bisher nicht gelungen, die mit dem zwangsweise bei n-Kanal-Transistoren auftretenden p⁺n⁺-Übergang zwischen der internen p⁺-Elektrode des Stapelkondensators und dem n⁺-Source/Drain-Anschlußgebiet auftretenden Probleme zu lösen. Es ist daher bisher nicht gelungen, bei n-Kanal-Transistoren Stapelkondensatoren unter Ausnutzung der selektiven Ätzbarkeit von p⁺-Polysilizium und p⁻-Polysilizium erfolgreich herzustellen.

Es ist somit Aufgabe der vorliegenden Erfindung, ein Verfahren zum Herstellen eines Stapelkondensators vorzusehen, das die selektive Ätzbarkeit von p⁺-Polysilizium und p⁻-Polysilizium ausnutzt und ohne weiteres bei n-Kanal-Transistoren eingesetzt werden kann.

Diese Aufgabe wird bei einem Verfahren der eingangs genannten Art erfindungsgemäß dadurch gelöst, daß nach dem Ätzen der einen Elektrode des Stapelkondensators eine Umdotierung der nach dem Ätzen verbleibenden Halbleiterschichten zum einen Leitfähigkeitstyp vorgenommen wird.

Die Erfindung beschreitet damit einen vom bisherigen Stand der Technik vollkommen abweichenden Weg: anstelle spezielle Metallisierungen oder Maßnahmen zu ergreifen, um die Nachteile auszuschließen, die mit dem zwangsläufig zwischen der p⁺-Elektrode und dem n⁺-Anschlußgebiet vorhandenen p⁺n⁺-Übergang verbunden sind, wird bei der Erfindung der p⁺n⁺-Übergang selbst beseitigt. Hierzu wird zunächst in bevorzugter Weise die p⁻-Elektrode des Kondensators nach Abätzen der p⁻-Schicht gegebenenfalls nach Abdeckung mit einer Siliziumdioxidschicht einer Temperung im Vakuum oder in einer geeigneten Gasatmosphäre aus Stickstoff unterworfen, bei der es zu einer starken Abreicherung der p⁺-Dotierung über die Oberfläche kommt. Da nämlich die Dicke der Lamellen der p⁺-Elektrode im Bereich unter 30 nm liegt, tritt bei üblichen Temperungen im Temperaturintervall zwischen etwa 750°C und 1150°C eine deutliche Abreicherung des p⁺-Dotierstoffes, also Bor, auf.

Anschließend wird sodann die Elektrode mit abgereicherter p-Dotierung durch Einbringen von beispielsweise Arsen oder Phosphor bis zur Sättigungsgrenze des Halbleitermaterials, also Silizium, oder darüber hinaus umdotiert. Für das Einbringen des Umdotierstoffes, im vorliegenden Beispiel also Arsen oder Phosphor, kann in bevorzugter Weise eine Ionenimplantation angewandt werden. Jedoch ist auch eine Belegung oder Ausdiffusion möglich.

Nach einer Nachbehandlung der Elektrode, beispielsweise einem Ausheilschritt bei einer Ionenimplantation oder einem Entfernen der Belegung, ist die Elektrode mit einer n⁻-Dotierung versehen und kann somit problemlos an das Anschlußgebiet des Transistors oder ein sonstiges n-leitendes Gebiet angeschlossen werden.

Bei den vorangehenden Erläuterungen wird davon ausgegangen, daß die Ätzselektivität zwischen p⁺-Polysilizium und p⁻-Polysilizium ausgenutzt wird, so daß der eine Leitfähigkeitstyp die n-Leitfähigkeit und der andere Leitfähigkeitstyp die p-Leitfähigkeit ist. Die vorliegende Erfindung ist jedoch auch dann in vorteilhafter Weise anwendbar, wenn die unterschiedlichen Ätzgeschwindigkeiten von verschieden stark dotierten n-leitenden Halbleiterschichten zur Bildung einer lamellenartigen Elektrode eines Stapelkondensators herangezogen werden, um eine dann vorliegende n-leitende Elektrode an ein p⁺-Anschlußgebiet anzuschließen.

Bei dem bevorzugten Ausführungsbeispiel der Erfindung, bei dem eine mit Bor dotierte Elektrode umdotiert wird, wird in vorteilhafter Weise ausgenutzt, daß Bor eine deutlich geringere Festkörperlöslichkeit in Silizium als beispielsweise Arsen oder Phosphor hat. Damit ist es möglich, die Umdotierung vorzunehmen. Außerdem wird hierbei ausgenutzt, daß die Lamellen der p⁺-Elektrode so dünn sind, daß bei der erwähnten Temperung im Vakuum oder in einer geeigneten Gasatmosphäre, sogar bei Abdeckung der Lamellen mit Siliziumdioxid oder Siliziumdioxid enthaltenden Schichten, ein bedeutender Teil des Bors in das die Elektrode umgebende Vakuum, die Atmosphäre oder die Siliziumdioxid-Deckschicht diffundiert und damit bereits schon vor der Umdotierung, beispielsweise durch Ionenimplantation von Arsen oder Phosphor, entfernt werden kann.

Ein nach dem erfindungsgemäßen Verfahren hergestellter Stapelkondensator zeichnet sich dadurch aus, daß in wenigstens einer seiner Elektroden aus polykristallinem Silizium, die mit Dotierstoff des einen Leitfähigkeitstyps hoch dotiert ist, Reste eines Dotierstoffes des anderen Leitfähigkeitstyps vorhanden sind.

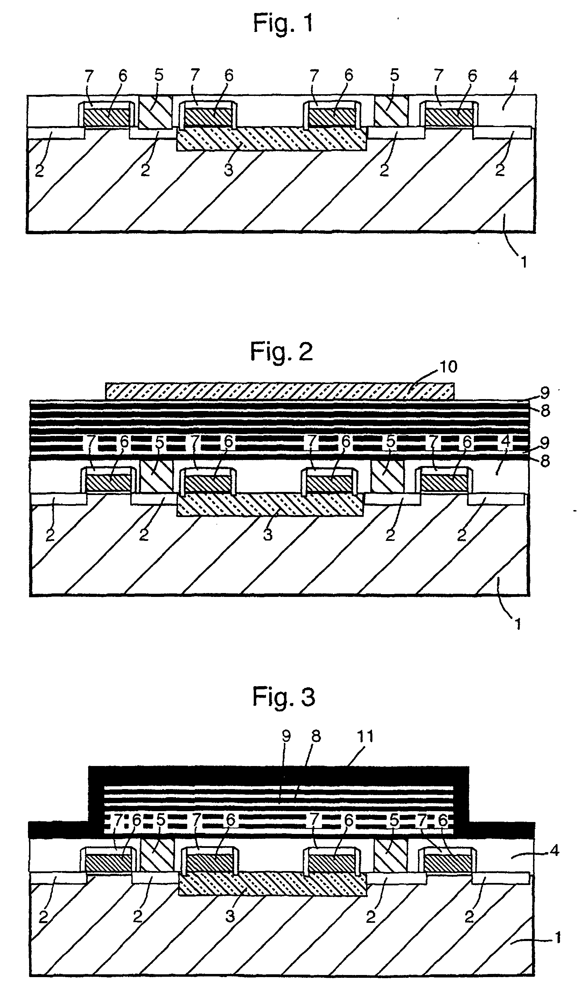

Nachfolgend wird die Erfindung anhand der Zeichnungen näher erläutert, in deren Fig. 1 bis 7 einzelne Schritte des erfindungsgemäßen Verfahrens zum Herstellen des Stapelkondensators veranschaulicht sind. Obwohl die Fig. 1 bis 7 dabei Schnitte durch die Halbleiteranordnung zeigen, sind aus Gründen der besseren Darstellbarkeit Schraffuren einzelner Teile bzw. Schichten weggelassen.

Fig. 1 zeigt einen p-leitenden Halbleiterkörper 1, in den in üblicher Weise n⁺-leitende Source/Drainzonen 2 eingebracht sind, wobei die Source/Drainzonen 2 von zwei Transistoren abwechselnd durch eine Isolationsschicht 3 getrennt sind. In einer auf dem Halbleiterkörper 1 angeordneten Siliziumdioxidschicht 4 befinden sich n⁺-leitende Anschlußgebiete 5 aus polykristallinem Silizium sowie Wortleitungen 6 aus n- oder p-leitendem polykristallinem Silizium, die senkrecht zur Zeichenebene verlaufen. Die Wortleitungen 6 sind mit einer Nitrid- oder Oxid-Einkapselung 7 aus Siliziumdioxid oder Siliziumnitrid versehen.

Die Herstellung der in Fig. 1 gezeigten Halbleiteranordnung erfolgt in üblicher Weise beispielsweise mittels LOCOS oder STI (Shallow Trench Isolation bzw. flache Grabenisolation), wobei bevorzugte Abmessungen beispielsweise 8 nm für das Gate-Oxid und 250 nm für die Polysiliziumschichten sind. Die Siliziumdioxidschicht 4 kann aus beispielsweise einer 300 nm dicken TEOS-Schicht bestehen.

Sodann wird auf die in Fig. 1 gezeigte Struktur eine Schichtenfolge aus mit Bor dotierten p⁺-Polysiliziumschichten 8 und p⁻-Polysiliziumschichten 9 aufgebracht, wie dies in Fig. 2 gezeigt ist. Dies kann beispielsweise durch chemische Dampfabscheidung (CVD) geschehen, um so eine Stapelstruktur dieser abwechselnd stark und schwach mit Bor dotierten Polysiliziumschichten 8, 9 zu erhalten. Die Dotierung der p⁻-Polysiliziumschichten ergibt sich teilweise aus "Speichereffekten": bei einer chemischen Dampfabscheidung der p⁺-Polysiliziumschichten 8 bleibt in der hierzu verwendeten Apparatur noch ausreichend Bor zurück, so daß nach Abstellen der Borzufuhr bei der anschließenden Aufbringung der nächsten Polysiliziumschicht noch ausreichend Bor vorhanden ist, um die p⁻-Polysiliziumschichten 9 zu ergeben.

Die p⁺-Polysiliziumschichten 8 und die p⁻-Polysiliziumschichten 9 werden in einer Schichtdicke von jeweils 20 nm erzeugt. Die Dotierstoffkonzentration der p⁺-Polysiliziumschichten 8 beträgt vorzugsweise 5 x 10²⁰ cm⁻³, die Dotierstoffkonzentration der p⁻-Polysiliziumschichten 9 1 x 10¹⁹ cm⁻³.

Mittels einer Photolack- und Ätztechnik wird sodann noch eine als Ätzmaske dienende Siliziumdioxidschicht 10 aufgetragen (vgl. Fig. 2).

Mit Hilfe der Siliziumdioxidschicht 10 werden die "Außenbereiche" der Polysiliziumschichten 8, 9 abgeätzt, wobei die Siliziumdioxidschicht 4 als Ätzstopp wirkt. Nach Entfernen der Siliziumdioxidschicht 10 wird auf die so erhaltene Struktur eine p⁺-Polysiliziumschicht 11 aufgetragen (Fig. 3). Für die Schichtdicke dieser Polysiliziumschicht 11 kann beispielsweise 40 nm gewählt werden.

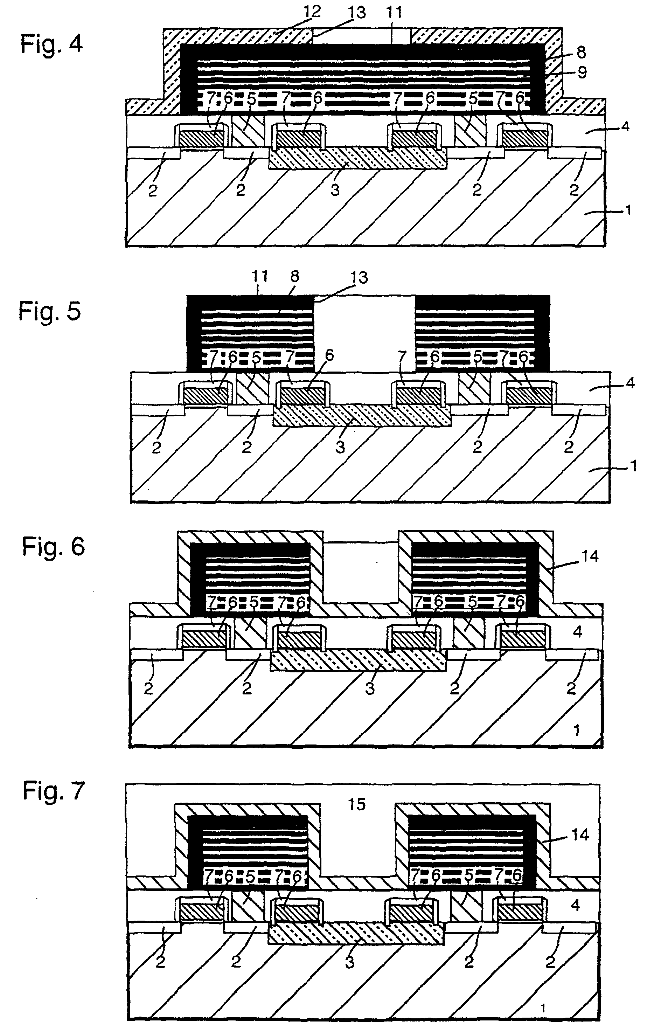

Sodann wird, wie in Fig. 4 gezeigt ist, eine etwa 150 nm dikke Siliziumdioxidschicht (TEOS) 12 aufgetragen, in die mittels der üblichen Photolack- und Ätztechnik ein Fenster 13 eingebracht wird. Damit liegt die in Fig. 4 gezeigte Struktur vor.

Durch das Fenster 13 werden die darunterliegenden Bereiche der p⁺- bzw. p⁻-Polysiliziumschichten 11 entfernt, wobei die Oberfläche der Siliziumdioxidschicht 4 wieder als Ätzstopp dient. Nach Abtragen der Siliziumdioxidschicht 12 beispielsweise durch Trockenätzung, erfolgt die selektive Ätzung der p⁺-Polysiliziumschichten 8 und der p⁻-Polysiliziumschichten 9. Dabei ist der Ätzabtrag der p⁻-Polysiliziumschichten 9 um einen Faktor 100 höher als der Ätzabtrag der p⁺-Polysiliziumschichten 8. Als Ätzmittel kann hierfür beispielsweise Cholin herangezogen werden.

Damit wird die in Fig. 5 gezeigte Anordnung erhälten, in welcher die p⁺-Polysiliziumschichten 8 lamellenartige Strukturen bilden, die auf drei Seiten, also auch vor und hinter der Zeichenebene parallel zu dieser, von der p⁺-Polysiliziumschicht 11 umgeben sind. Die lamellenartigen Strukturen aus den Polysiliziumschichten 8 liegen somit unterhalb des Bereiches des Fensters 13 frei, wie dies in Fig. 5 gezeigt ist.

Die Dicke der einzelnen Lamellen, die durch die p⁺-Polysiliziumschichten 8 gebildet sind, liegt unter 30 nm. Durch eine anschließende Temperung bei Temperaturen zwischen 750 und 1150°C tritt dann eine deutliche Abreicherung des Dotierstoffes Bor in diesen Polysiliziumschichten 8 auf.

Die nun anschließende erfindungsgemäße Umdotierung der Polysiliziumschichten 8, 11 kann auf verschiedene Weise vorgenommen werden. So ist es möglich, diese Umdotierung durch Ionenimplantation zu bewirken, wobei die Implantationsenergie zweckmäßigerweise so eingestellt wird, daß Maxima jeweils im Bereich der einzelnen Lamellen auftreten. Es ist aber auch möglich, die Lamellen mit entsprechendem Dotierstoff zu belegen.

Ebenso ist es möglich, vor der erwähnten Temperung einen dünnen Oxidfilm auf die Lamellen aufzutragen und erst dann die Temperung vorzunehmen. In diesem Fall bildet die Oxidschicht eine Dotierstoffsenke für das Bor bei einer anschließenden Temperaturbehandlung.

Zusammenfassend kann also die Ausdiffusion von Bor aus den Polysiliziumschichten 8 durch Temperung oder durch Belegung oder Oxidation zur Bildung einer Dotierstoffsenke und eine Temperung erfolgen. Nach Reinigung (bei Ausdiffusion von Bor) oder Entfernung der dotierten Oberflächenschicht (bei Belegung oder Oxidation zur Bildung der Dotierstoffsenke) wird die Umdotierung mittels Arsen oder Phosphor vorgenommen. Dies kann durch Implantation oder durch Belegung mit Arsen- oder Phosphorglas und durch Eindiffusion des Dotierstoffes erfolgen.

Nach einer erneuten Temperung, insbesondere bei einer Implantation, hat damit die in Fig. 5 gezeigte Halbleiteranordnung eine n⁺-Dotierung (mit Phosphor oder Arsen) in den Polysiliziumschichten 8, 11. Die Umdotierung von Bor zu Phosphor bzw. Arsen verläuft ohne große Probleme, da das Bor eine deutlich geringere Festkörperlöslichkeit in Silizium hat als Arsen oder Phosphor. Auch wird die Umdotierung dadurch begünstigt, daß die Abreicherung in den lamellenartigen Polysiliziumschichten 8 infolge von deren geringen Schichtdicke unter 30 nm schon vor der eigentlichen Umdotierung die Dotierungskonzentration in diesen Schichten 8 stark absinken läßt.

Es schließt sich sodann noch die Auftragung des Kondensator-Dielektrikums aus ON- bzw. ONO-Schichten an, die auf die lamellenartigen Polysiliziumschichten 8 aufgetragen werden. Diese ON- bzw. ONO-Schichten sind in den Figuren nicht gezeigt. Sie umhüllen aber die Oberflächen der Polysiliziumschichten 8, 11, so daß diese von einer anschließend aufgetragenen Gegenelektrode 14 aus n⁺-Polysilizium dielektrisch getrennt sind (vgl. Fig. 6). Die Schichtdicke der ON- bzw. ONO-Schichten beträgt etwa 3 nm.

Nach einer Strukturierung der n⁺-Polysiliziumschicht 14 (in den Figuren nicht gezeigt) wird noch eine Siliziumdioxidschicht 15 (TEOS) aufgetragen und planarisiert, woran sich die üblichen Metallisierungsprozesse anschließen.

Wesentlich an der Erfindung ist die Umdotierung der Polysiliziumschichten 8, 11, die ursprünglich mit Bor dotiert sind, um die Ätzselektivität von schwach und stark dotiertem p-Polysilizium auszunutzen. Durch die Umdotierung wird erreicht, daß diese Polysiliziumschichten 8, 11 den gleichen Leitfähigkeitstyp wie das Anschlußgebiet 5 haben, so daß zwischen der durch die Polysiliziumschichten 8, 11 gebildeten Elektrode des Kondensators und dem Anschlußgebiet 5 kein pn-Übergang mehr vorliegt.

## Patentansprüche

1. Verfahren zum Herstellen eines Stapelkondensators in einer Halbleiteranordnung, bei dem eine Elektrode des Stapelkondensators über ein Anschlußgebiet (5) des einen Leitfähigkeitstyps mit Source oder Drain (2) eines Transistors verbunden ist und bei dem die eine Elektrode des Stapelkondensators unter Ausnutzung der unterschiedlichen Ätzgeschwindigkeiten von verschieden stark dotierten Halbleiterschichten (8, 9) des anderen Leitfähigkeitstyps erzeugt wird, **dadurch gekennzeichnet, daß** nach dem Ätzen der einen Elektrode des Stapelkondensators eine Umdotierung der nach dem Ätzen verbleibenden Halbleiterschichten zum einen Leitfähigkeitstyp vorgenommen wird.

2. Verfahren nach Anspruch 1, **dadurch gekennzeichnet, daß** als Dotierstoff für den anderen Leitfähigkeitstyp Bor verwendet wird.

3. Verfahren nach Anspruch 2, **dadurch gekennzeichnet, daß** die Umdotierung durch Ionenimplantation von Arsen oder Phosphor oder durch Belegung mit Arsen- oder Phosphorglas und durch Eindiffusion von Arsen oder Phosphor vorgenommen wird.

4. Verfahren nach einem der Ansprüche 1 bis 3, **dadurch gekennzeichnet, daß** vor der Umdotierung eine Abreicherung des Dotierstoffes des anderen Leitfähigkeitstyps durch eine Temperung vorgenommen wird.

5. Verfahren nach Anspruch 4, **dadurch gekennzeichnet, daß** die Temperung zwischen 750 und 1150°C vorgenommen wird.

6. Verfahren nach einem der Ansprüche 1 bis 5, **dadurch gekennzeichnet, daß** die Umdotierung bis über die Sättigungsgrenze des Halbleitermaterials der Halbleiterschichten hinaus vorgenommen wird.

7. Verfahren nach Anspruch 4, **dadurch gekennzeichnet, daß** vor der Temperung zur Abreicherung des Dotierstoffes des anderen Leitfähigkeitstyps eine Belegung oder Oxidation der Halbleiterschichten (8) zur Bildung einer Dotierstoffsenke vorgenommen wird.

8. Verfahren nach einem der Ansprüche 1 bis 7, **dadurch gekennzeichnet, daß** die verbleibenden Halbleiterschichten (8) mit einer Schichtdicke von unter 30 nm versehen werden.

## Claims

1. Method for fabricating a stacked capacitor in a semiconductor arrangement, in which one electrode of the stacked capacitor is connected via a terminal region (5) of the first conductivity type to source or drain (2) of a transistor, and in which the one electrode of the stacked capacitor is produced by utilizing the different etching rates of semiconductor layers (8,9) of the second conductivity type which are doped to different extents,
**characterized in that** after the etching of the one electrode of the stacked capacitor, doping reversal of the semiconductor layers remaining after the etching operation to the first conductivity type is performed.

2. Method according to Claim 1, **characterized in that** boron is used as the dopant for the second conductivity type.

3. Method according to Claim 2, **characterized in that** the doping reversal is performed by ion implantation of arsenic or phosphorus or by coating with arsenic or phosphorus glass and by indiffusion of arsenic or phosphorus.

4. Method according to one of Claims 1 to 3, **characterized in that** prior to the doping reversal, a depletion of the dopant of the second conductivity type is performed by means of a heat treatment.

5. Method according to Claim 4, **characterized in that** the heat treatment is performed between 750 and 1150°C.

6. Method according to one of Claims 1 to 5, **characterized in that** the doping reversal is performed to a point beyond the saturation limit of the semiconductor material of the semiconductor layers.

7. Method according to Claim 4, **characterized in that** prior to the heat treatment for depleting the dopant of the second conductivity type, coating or oxidation of the semiconductor layers (8) is performed for the purpose of forming a dopant sink.

8. Method according to one of Claims 1 to 7, **characterized in that** the remaining semiconductor layers (8) are provided with a layer thickness of less than 30 nm.

## Revendications

1. Procédé de fabrication d'un condensateur empilé dans un dispositif à semi-conducteur dans lequel on relie l'électrode du condensateur empilé par l'intermédiaire d'une zone (5) de connexion d'un premier type de conductivité à la source ou au drain (2) d'un transistor et dans lequel on produit ladite électrode du condensateur empilé en tirant parti des vitesses différentes d'attaque de différentes couches (8, 9) semi-conductrices fortement dopées ayant l'autre type de conductivité,
**caractérisé en ce que** l'on effectue, après l'attaque de ladite électrode du condensateur empilé, une modification du dopage des couches semi-conductrices restant après l'attaque pour leur donner le premier type de conductivité.

2. Procédé selon la revendication 1, **caractérisé en ce qu'**il consiste à utiliser comme substance de dopage pour l'autre type de conductivité du bore.

3. Procédé selon la revendication 2, **caractérisé en ce qu'**il consiste à modifier le dopage par implantation d'ions d'arsenic ou de phosphore ou par garnissage à l'aide de verre à l'arsenic ou de verre au phosphore et par diffusion d'arsenic ou de phosphore.

4. Procédé selon l'une des revendications 1 à 3, **caractérisé en ce qu'**il consiste à effectuer avant la modification du dopage un appauvrissement en la substance de dopage de l'autre type de conductivité par un traitement thermique.

5. Procédé selon la revendication 4, **caractérisé en ce qu'**il consiste à effectuer le traitement thermique entre 750 et 1150°C.

6. Procédé selon l'une des revendications 1 à 5, **caractérisé en ce qu'**il consiste à effectuer la modification de dopage jusqu'au-delà de la limite de saturation du matériau semi-conducteur des couches semi-conductrices.

7. Procédé selon la revendication 4, **caractérisé en ce qu'**il consiste à effectuer avant le traitement thermique, pour obtenir un appauvrissement à la substance de dopage de l'autre type de conductivité, un garnissage ou une oxydation des couches humides semi-conductrices afin de former un puits de substance de dopage.

8. Procédé selon l'une des revendications 1 à 7, **caractérisé en ce que** l'on donne aux couches (8) semi-conductrices restantes une épaisseur inférieure à 30 nm.
